# EUROPEAN PATENT APPLICATION

(11) **EP 4 538 900 A1**
(43) Date of publication of application: **16.04.2025**
(21) Application number: 24204696.9
(22) Date of filing: 04.10.2024
(51) Int. Cl.: G06F 13/40, G06F 13/42, G06F 15/173

(54) **CIRCUITS FOR CONVERTING BETWEEN STREAMING DATA PROTOCOLS, AND METHODS OF USE THEREOF**

(30) Priority: 09.10.2023 US 202363588872 P; 23.09.2024 US 202418893707
(71) Applicant: Jariet Technologies, Inc., Redondo Beach, California 90277 (US)
(72) Inventor: POWELL, Scott Richard, Redondo Beach, 90277 (US); REUTEMANN, Robert Ernst, Redondo Beach, 90277 (US)
(74) Representative: Epping - Hermann - Fischer

(57) **Abstract**

An example semiconductor device includes a first semiconductor die including a morph-link circuit and a first interface circuit. The morph-link circuit is configured to receive streaming data formatted in a first format according to a first protocol, the streaming data comprising a plurality of data bits in the first format and a plurality of control bits in the first format; and convert the streaming data to a second format according to a second protocol, including separating the plurality of control bits from the plurality of data bits. The morph-link circuit is further configured to transmit the streaming data in the second format to the first interface circuit, including transmitting the plurality of data bits in the second format via a first communication channel to the first interface circuit and transmitting control information corresponding to the plurality of control bits via a second communication channel to the first interface circuit.

## Description

### CROSS-REFERENCE TO RELATED APPLICATIONS

This application claims the benefit of and priority to U.S. Provisional Patent Application No. 63/588,872, filed October 9, 2023, the entire contents of which are incorporated herein by reference for all purposes.

### TECHNICAL FIELD

he disclosed embodiments relate to systems, devices, circuits, dies, and interfaces, including, without limitation, circuits and methods for converting streaming data between different formats.

### BACKGROUND

Digitized signal processing chiplets naturally produce, or consume, a continuous stream of digitized samples (e.g., in communications, radar, transceivers, modems, and data converters). Packet-based protocols are not ideal for streaming data as they introduce protocol overhead that may require gaps in transmission, lower data rates, and/or require buffers. Additionally, the acknowledgement and/or retransmission capabilities of packet-based protocols may not be applicable to streaming data.

Universal chiplet interconnect express (UCIe) is an open standard for high-rate digital data communications between multiple dies or chiplets in a single package. The high data rate in UCIe is achieved using parallel interconnection lanes between die on the same package substrate (e.g., each lane caries a portion of a composite digital data bandwidth). Each lane may operate at 4, 8, 12, 16, 24, or 32 Gbps. Additionally, the lanes may be treated as point-to-point connections with both ends sharing a common clock. The UCIe standard specifies interoperation over two different package types, standard (e.g., using traditional packaging technology) and advanced (e.g., using fine line packaging technology). The UCIe standard supports streaming data (e.g., raw data with no framing overhead or packetized flit data with overhead). The term "Standard UCle" may refer to a standardized UCIe interface, which may support both standard and advanced package interconnects.

JESD 204 family of protocols (e.g., 204A, 204B, 204C, and 204D) define a standard mechanism for transporting streaming digitized data over multiple serial lanes (e.g., multiple lanes in parallel, where each lane carries data serially). A JESD interface may receive data samples (e.g., parallel 8-bit data samples) from a signal converter and convert them into output bit streams. JESD 204 supports point-to-point connections with both ends sharing a common clock, individual lanes carrying portions of composite digital data, and up to 32 Gbps per lane, for 204C, and higher rates for 204D. In this way, JESD 204 matches well with the UCIe standard. JESD 204 is used as a protocol layer for streaming data across parallel high-speed serial connections (e.g., between two chips).

However, there is no standard streaming protocol defined for UCIe. For example, UCIe defines a raw streaming interface but does not define a framing mechanism (e.g., leaves the protocol as vendor defined). Therefore, streaming UCIe chiplets (or raw streaming UCIe chiplets) from multiple vendors may not interoperate. Therefore, there is a need for being able to convert streaming data in a first protocol (e.g., JESD 204) to a second protocol (e.g., UCIe for transmission between multiple dies or chiplets).

The description in the background section includes information that describes one or more aspects of the subject technology, and the description in this section does not limit the invention.

### SUMMARY

The present disclosure describes, amongst other things, example circuits, components, devices, and methods for converting between streaming data with a first format (e.g., corresponding to a first protocol) and a second format (e.g., corresponding to a second protocol). For example, a morph-link circuit (also sometimes referred to as a "bridge") may be configured to convert between JESD 204 formatted data (e.g., JESD 204C formatted data) and UCIe formatted data. The conversion may include separating control bits from the data bits (e.g., so that the control bits can be transmitted concurrently with the data bits). In this way, the converted streaming data may be transmitted between dies/chiplets using a protocol (e.g., a standard protocol such as UCIe) with parallel interconnection lanes without lowering the data rate.

In accordance with some embodiments, a semiconductor device includes a first semiconductor die including a morph-link circuit and a first interface circuit. The morph-link circuit is configured to: (i) receive streaming data formatted in a first format according to a first protocol, the streaming data comprising a plurality of data bits in the first format and a plurality of control bits in the first format; (ii) convert the streaming data to a second format according to a second protocol, including separating the plurality of control bits from the plurality of data bits; and (iii) transmit the streaming data in the second format to the first interface circuit. The first interface circuit is configured to cause: (a) transmitting the plurality of data bits in the second format to a second interface circuit disposed outside the first semiconductor die according to the second protocol; and (b) transmitting, separately from the plurality of data bits in the second format, the control information in the second format to the second interface circuit according to the second protocol.

In accordance with some embodiments, a method of operating a semiconductor device includes: (i) receiving, at a morph-link circuit, streaming data formatted in a first format according to a first protocol, the streaming data comprising a plurality of data bits in the first format and a plurality of control bits in the first format; (ii) converting, at the morph-link circuit, the streaming data to a second format according to a second protocol, including separating the plurality of control bits from the plurality of data bits; and (iii) transmitting the streaming data in the second format from the morph-link circuit to a first interface circuit, including transmitting the plurality of data bits in the second format via a first communication channel to the first interface circuit and transmitting control information corresponding to the plurality of control bits via a second communication channel to the first interface circuit; (iv) transmitting the plurality of data bits in the second format from the first interface circuit to a second interface circuit according to the second protocol; and (v) transmitting the control information in the second format from the first interface circuit to the second interface circuit.

In accordance with some embodiments, a semiconductor device includes a first semiconductor die including a morph-link circuit and a first interface circuit. The morph-link circuit is configured to: (i) receive streaming data formatted in a first format according to a first protocol, the streaming data comprising a plurality of data bits in the first format and a plurality of control bits in the first format; (ii) convert the streaming data to a second format according to a second protocol, including separating the plurality of control bits from the plurality of data bits; and (iii) transmit the streaming data in the second format to the first interface circuit. The first interface circuit is configured to cause: (a) transmitting the plurality of data bits in the second format to a second interface circuit disposed outside the first semiconductor die according to the second protocol; and (b) transmitting, separately from the plurality of data bits in the second format, the control information in the second format to the second interface circuit according to the second protocol.

The features and advantages described in the specification are not necessarily all-inclusive and, in particular, some additional features and advantages will be apparent to one of ordinary skill in the art in view of the drawings, specification, and claims provided in this disclosure. Moreover, it should be noted that the language used in the specification has been principally selected for readability and instructional purposes and has not necessarily been selected to delineate or circumscribe the subject matter described herein. Nothing in this section should be taken as a limitation on those claims. Further aspects and advantages are discussed below in conjunction with example embodiments of the present disclosure.

It is to be understood that both the foregoing description and the following description of the present disclosure are examples, and are intended to provide further explanation of the disclosure as claimed.

### BRIEF DESCRIPTION OF THE DRAWINGS

So that the present disclosure can be understood in greater detail, a more particular description can be had by reference to the features of various embodiments, some of which are illustrated in the appended drawings. The appended drawings, however, merely illustrate pertinent features of the present disclosure and are therefore not necessarily to be considered limiting, for the description can admit to other effective features as the person of skill in this art will appreciate upon reading this disclosure.
Figure ("FIG.") 1A illustrates a schematic top-down plan view of an example multi-die package including semiconductor dies having morph-link circuits in accordance with some embodiments.
Figure 1B illustrates an example operation of the multi-die package of Figure 1A in accordance with some embodiments.
Figures 2A-2B illustrate an example operation of an example multi-die package in accordance with some embodiments.
Figure 3A illustrates an example timing diagram of a source clock and a sink (destination) clock in accordance with some embodiments.
Figures 3B-3D illustrate example buffer operations for absorbing differences between source and sink clocks in accordance with some embodiments.
Figure 4 illustrates an example method of operating a semiconductor device in accordance with some embodiments.

In accordance with common practice, the various features illustrated in the drawings are not necessarily drawn to scale, and like reference numerals can be used to denote like features throughout the specification and figures.

### DETAILED DESCRIPTION

The present disclosure describes, amongst other things, converting streaming data from a first format (e.g., having control bits interwoven with data bits) to a second format (e.g., having control bits signaled separately from data bits). For example, streaming data formatted according to JESD 204 may be converted to a UCIe format (e.g., and transmitted via a standard or advanced UCIe interface). An advantage of converting the streaming data to the second format is that the data may be transmitted at high speed using a set of parallel interconnection lanes without lowering the data rate by transmitting control bits interwoven with the data bits (e.g., the control bits, or control information may be signaled in a sideband channel).

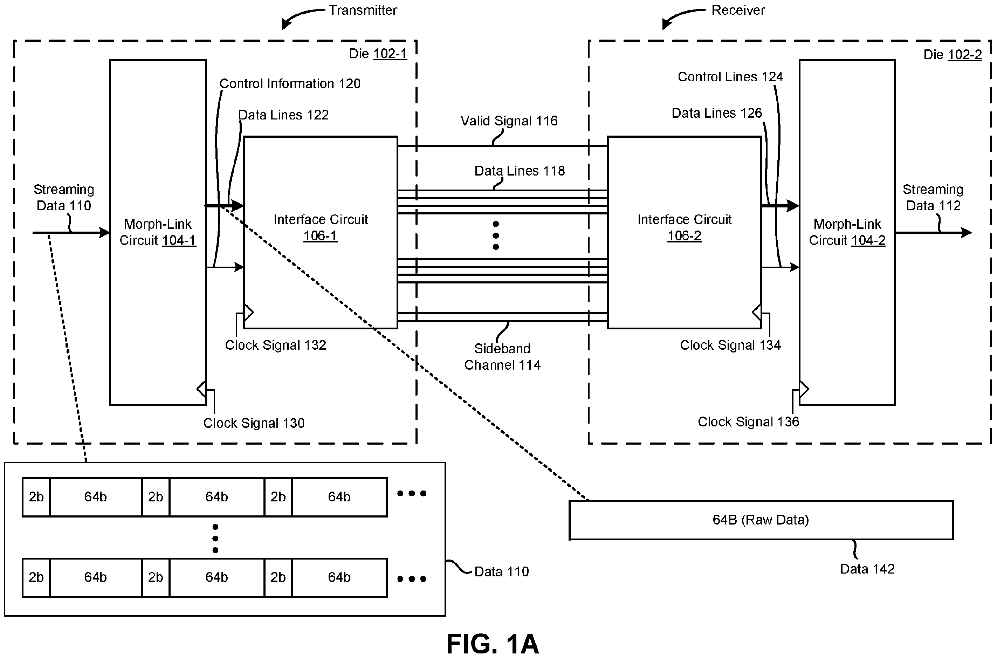

Figure 1A illustrates a schematic top-down plan view of an example multi-die package that includes semiconductor dies 102 (e.g., die 102-1 and die 102-2) having morph-link circuits in accordance with some embodiments. The multiple-die package includes semiconductor dies 102-1 and 102-2 disposed (e.g., mounted) on a package substrate. The dies 102-1 and 102-2 may be connected using standard package interconnects or advanced package interconnects. The standard package interconnects may represent interconnects that are less complex or less technically advanced than the advanced package interconnects. In some embodiments, the advanced package interconnects have more stringent requirements (e.g., regarding interconnect length, component pitch, and the like) as compared to the standard package interconnects. As an example, the standard package interconnects may be UCIe standard package interconnects and the advanced package interconnects may be UCIe advanced package interconnects.

In the example of Figure 1A, the die 102-1 is a transmitter and the die 102-2 is a receiver (e.g., data flows from the die 102-1 to the die 102-2). The die 102-1 includes a morph-link circuit 104-1 and an interface circuit 106-1. In some embodiments, the die 102-1 includes analog logic components, digital logic components, an analog-to-digital converter, and/or other signal processing components. The morph-link circuit 104-1 receives streaming data 110 and outputs data 142 on data lines 122 and control information 120. In some embodiments, the streaming data 110 is formatted in accordance with JESD 204 protocols. In some embodiments, the data 142 is raw data (containing no control bits). In some embodiments, the data 142 is formatted in accordance with UCIe protocols. In some embodiments, the interface circuit 106-1 comprises a UCIe interface (e.g., configured for a standard or advanced interconnect package).

In some embodiments, the die 102-1 includes a JESD interface configured to generate the streaming data 110. In some embodiments, the JESD interface receive data samples (e.g., parallel 8-bit data samples) from a source and converts them into output bit streams (e.g., the streaming data 110). In Figure 1A, the streaming data 110 is illustrated as JESD 64b/66b formatted parallel bit streams. In this example, the bit streams from the JESD interface includes bit streams that are in parallel lanes, where each lane includes 2-bit framing marker bits followed by 64-bit data bits, followed by 2-bit framing marker bits, followed by 64-bit data bits and so on. The 2-bit framing marker bits may be sometimes referred to as 2-bit sync bits, and these may be control bits or control signals. The 64-bit data bits represent data or data signals (as opposed to control signals or control bits). A framing marker may be sometimes referred to as a frame marker, an indicator of a frame boundary, an indicator for a location of a multi-bit data sample, an indicator for a multi-bit data sample boundary. In Figure 1A, the notation "b" (see, e.g., 2b or 64b in the data 110) represents "bit," and the notation "B" (see e.g., 64B in the data 142) represents "byte."

In some embodiments, a JESD interface is replaced with another interface supporting standardized streaming protocols, an interface supporting transport of data within a die, a streaming data interface, a first interface, a first interface block, a first interface circuit, or a first interface circuit block.

In some embodiments, a UCIe interface is replaced with another interface supporting die-to-die interconnect protocols, an interconnect interface, a second interface, a second interface block, a second interface circuit, or a second interface circuit block.

The morph-link circuit 104-1 may receive the bit streams from the JESD interface and convert them into (and output) the data 142 (e.g., one or more bit streams) that comply with UCIe protocols. In some embodiments, the data 142 generated by the morph-link circuit 104-1 comprises UCIe raw streaming frames and is in a UCIe raw streaming format. For example, the data 142 may be in a 64-byte UCIe raw streaming format with no overhead (no control signals). From the streaming data 110 received from the JESD interface, the morph-link circuit 104-1 may remove the framing marker bits and output the framing marker bits separately from the data 142 (e.g., outputs the framing marker bits as the control information 120). Hence, the control information 120 (e.g., the framing markers) is not part of the data 142 (e.g., which is in a 64-byte UCIe raw streaming format). The morph-link circuit 104-1 may receive other control signals or messages (e.g., vendor defined messages) and output them along with the framing marker bits separately (e.g., as the control information 120). Hence, the other control signals or messages (e.g., vendor defined messages) are not part of the data 142 (e.g., the bit streams).

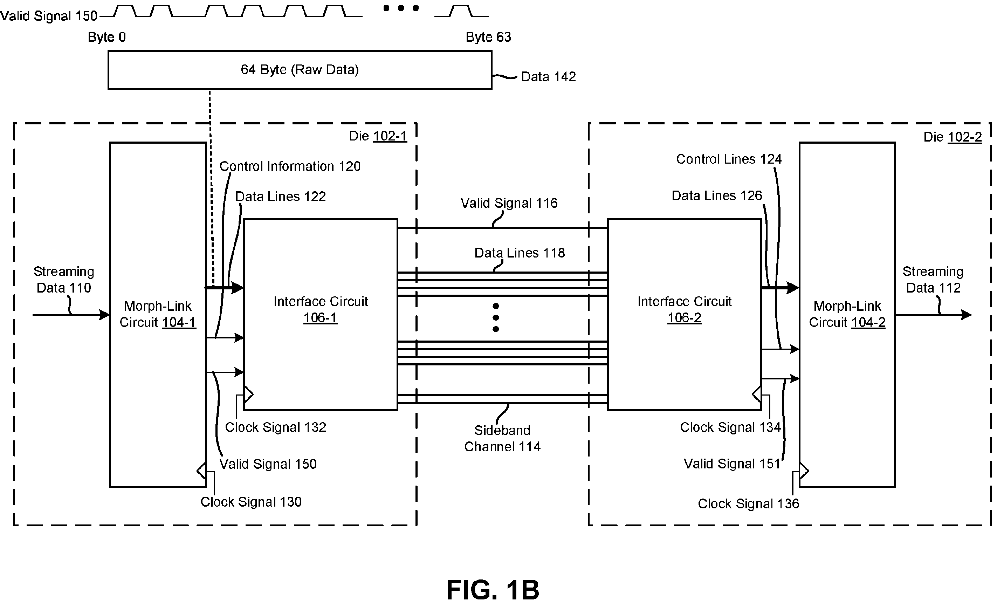

In some embodiments, the morph-link circuit 104-1 outputs an indicator to indicate which output data is valid (e.g., which portions of the data 142 are valid) as illustrated in Figure 1B. For example, to comply with the UCIe protocol, the morph-link circuit 104-1 may also generate (and output) an indicator for valid data or a valid track (or a validity indicator) (e.g., an indicator showing whether data or bits in the bit stream are valid or invalid). Thus, the morph-link circuit 104-1 may output (a) a bit stream in a raw format carrying only data or data signals (without control signals), (b) control signals, such as framing markers and other vendor defined messages, separately from the bit stream, and (c) a validity indicator (separately from the bit stream and the control signals).

As shown in Figure 1A, the interface circuit 106-1 receives from the morph-link circuit 104-1 the data 142 via the data lines 122, the control information 120, and optionally, a validity indicator. The interface circuit 106-1 may then output the data 142 via the data lines 118, the control information 120 (e.g., framing markers and other vendor defined messages) via the sideband channel 114, and the valid signal 116 indicating what portions of the data 142 are valid. In some embodiments, the morph-link circuit 104-1 and the interface circuit 106-1 operate at a same speed (e.g., using a same clock). Thus, as discussed in more detail below, in some embodiments, the clock signal 130 is the same as the clock signal 132. In some embodiments, the clock signal 130 has a faster clock rate (e.g., has a shorter period) than the clock signal 132. In some embodiments, the clock signal 134 has a same clock rate as the clock signal 136. In some embodiments the clock signals 130, 132, 134, and 136 are the same (e.g., derived from the same clock generator). In some embodiments, the clock signals 130 and 136 are the same and the clock signals 132 and 134 are the same.

In some embodiments, the interface circuit 106-1 receives the data 142 in a serial manner from the morph-link circuit 104-1. For example, the data 142 may be sent over a single data line or the data 142 may be sent serially over a set of the data lines 122. The interface circuit 106-1 may receive the data 142 in a serial manner and transmit the data 142 in a more parallelized manner over the data lines 118. For example, the data lines 118 may include more lines than the data lines 122.

In the example of Figure 1A, the die 102-2 is a receiver configured and coupled to receive data from the die 102-1. In accordance with some embodiments, the die 102-2 includes an interface circuit 106-2 (e.g., a UCIe interface) and a morph-link circuit 104-2 (e.g., configured to convert data in a UCIe format to data in a streaming format). In some embodiments, the interface circuit 106-2 is configured to receive the data 142 via the data lines 118 and the control information 120 via the sideband channel 114. In some embodiments, the interface circuit is configured to transmit the data 142 to the morph-link circuit 104-2 via the data lines 126 and transmit the control information 120 to the morph-link circuit 104-2 via the control lines 124. In some embodiments, the morph-link circuit 104-2 is configured to convert the data 142 and the control information 120 to streaming data 112. In some embodiments, the streaming data 112 is the same as the streaming data 110. In some embodiments, the streaming data 112 includes the same framing information as the streaming data 110, but is not identical to the streaming data 110. In some embodiments, the die 102-2 includes a JESD interface coupled to the morph-link circuit 104-2 (e.g., configured to receive the streaming data 112). In some embodiments, the interface circuit 106-2 includes the same subcomponents/structures and/or performs the same (and/or complimentary) functions as the interface circuit 106-1. In some embodiments, the morph-link circuit 104-2 includes the same subcomponents/structures and/or performs the same (and/or complimentary) functions as the morph-link circuit 104-2. In some embodiments, the morph-link circuits 104 and the interface circuits 106 are configured to provide the streaming data 112 at the die 102-2 that matches the streaming data 110 at the die 102-1. In some embodiments, the die 102-2 includes additional analog and/or digital circuitry (e.g., logic circuits and/or signal converts). In some embodiments, the die 102-1 and the die 102-2 are configured to perform a same and/or complementary set of functions. In some embodiments, the die 102-1 and the die 102-2 are configured to perform different functions.

As mentioned above, the die 102-1 may be configured to operate in different modes based on the data rates for the morph-link circuit 104-1 and the interface circuit 106-1. For example, a first mode may correspond to the data rate being the same (e.g., the clock signal 130 being the same as the clock signal 132). A second mode may correspond to the data rates being different (e.g., the clock signal 130 being faster (having a shorter period) than the clock signal 132).

In some embodiments, the morph-link circuit 104-1 (e.g., and the morph-link circuit 104-2) is configured to operate in one of three modes (e.g., denoted as Mode 1, Mode 2, and Mode 3). In some embodiments, when the morph-link circuit 104-1 selects Mode 1, the same Mode 1 is selected for the morph-link circuit 104-2. Similarly, if Mode 2 is selected for the morph-link circuit 104-1, then the same Mode 2 is selected for the morph-link circuit 104-2. Similarly, if Mode 3 is selected for the morph-link circuit 104-1, then the same Mode 3 is selected for the morph-link circuit 104-2.

As an example, Mode 1 may be selected when the composite sample data rate (bits/sec) of the streaming data 110 is equal to the composite data rate of the data 142 transmitted by the interface circuit 106-1. A composite data rate may be calculated by multiplying the number of parallel lanes by the data rate of each lane. For example, if the streaming data 110 is provided in 16 parallel lanes, and the data rate of each lane is 16 Gbps for data (e.g., excluding control signals, such as frame markers), then the composite sample data rate of data for the streaming data 110 is 256 Gbps (16 times 16 Gbps). If the interface circuit 106-1 supports 32 parallel high speed data lanes (e.g., the data lines 118 consist of 32 lines), and the data rate of each lane is 8 Gbps for data, then the composite data rate of data for the interface circuit 106-1 is 256 Gbps (32 times 8 Gbps). In this example, because the composite data rate for the streaming data 110 is the same as the composite data rate for the interface circuit 106-1, Mode 1 is selected.

Mode 2 may be selected when the composite sample data rate (bits/sec) of the streaming data 110 is less than the composite data rate of data at the interface circuit 106-1. Mode 3 may be applicable when the composite sample data rate (bits/sec) of streaming data 110 is greater than the composite data rate of data at the interface circuit 106-1.

Mode 3 may have two sub-modes: Mode 3-1 (which is the same as or similar to Mode 1); and Mode 3-2 (which is the same as or similar to Mode 2). For Mode 3, the morph-link circuit 104-1 may, for example, remove some of the data from the streaming data 110 so that the composite sample data rate (bits/sec) of the streaming data 110 is equal to the composite data rate of data at the interface circuit 106-1, in which case Mode 3-1 is selected, and the operations according to Mode 1 can be carried out on the data that is not removed. If, however, more data is removed so that the composite sample data rate (bits/sec) of the streaming data 110 is less than the composite data rate of data at the interface circuit 106-1, then Mode 3-2 is selected, and the operations according to Mode 2 can be carried out on the data kept (the data that is not removed). As Mode 3-1 is the same as or similar to Mode 1, and Mode 3-2 is the same as or similar to Mode 2, while Mode 1 and Mode 2 are described in more detail below, repetitive descriptions for Mode 3-1 and Mode 3-2 are omitted for brevity.

In examples in which the streaming data 110 is generated by a JESD circuit, a composite sample data rate (bits/sec) of the streaming data 110 may be sometime referred to as (a) a composite data rate of/for a JESD interface, (b) a composite data rate of/for JESD, or (c) a composite JESD data rate or the like. In examples in which the interface circuit 106-1 is a UCIe interface circuit, a composite data rate of data at the interface circuit 106-1 may be sometime referred to as (a) a composite data rate of/for the UCIe interface, (b) a composite data rate of/for UCIe, or (c) a composite UCIe data rate or the like. In one or more aspects, a composite data rate at the morph-link circuit 104-1 may be sometime referred to as (a) a composite data rate of/for the morph-link circuit 104-1 or (b) a composite streaming adapter data rate or the like. In one or more aspects, a sample data rate of data at a JESD interface may be sometime referred to as (a) a sample data rate of/for the JESD interface, (b) a data rate of/for JESD, or (c) a JESD data rate or the like. In one or more aspects, a data rate of data at a UCIe interface may be sometime referred to as (a) a data rate of/for the UCIe interface, (b) a data rate of/for UCIe, or (c) a UCIe data rate or the like. In one or more aspects, a data rate at a morph-link circuit may be sometime referred to as (a) a data rate of/for the streaming adapter or (b) a streaming adapter data rate or the like.

As noted above, a data rate may sometime refer to a composite data rate. As described above, a composite data rate may be calculated by multiplying the number of parallel lanes and the data rate of each lane. Similarly, a composite clock rate may be calculated by multiplying the number of parallel lanes and the clock rate of each lane. Hence, if there are 10 lanes, and the clock rate of each lane is 8 Gbps, then the composite clock rate is 80 Gbps.

In one or more aspects, a composite clock rate at a JESD interface may be sometime referred to as (a) a composite clock rate of/for the JESD interface, (b) a composite clock rate of/for JESD, or (c) a composite JESD clock rate or the like. In one or more aspects, a composite clock rate at a UCIe interface (e.g., the interface circuit 106-1) may be sometime referred to as (a) a composite clock rate of/for the UCIe interface, (b) a composite clock rate of/for UCIe, or (c) a composite UCIe clock rate or the like. In one or more aspects, a composite clock rate at a streaming adapter (e.g., the morph-link circuit 104-1) may be sometime referred to as (a) a composite clock rate of/for the streaming adapter or (b) a composite streaming adapter clock rate or the like. As noted above, a clock rate may sometime refer to a composite clock rate.

Referring to Figure 1A, Mode 1 is illustrated using one or more examples. The streaming data 110 (e.g., bit streams outputted from a JESD interface) have framing markers to indicate the starting/ending locations of the frames. However, a bit stream in a UCIe raw streaming format (e.g., the data 142, a bit stream being received by the interface circuit 106-1, or a bit stream transmitted to the interface circuit 106-2 of the die 102-2) carries only data and does not carry any control signals; hence, such bit stream does not include any frame markers. Thus, in some embodiments, the morph-link circuit 104-1 needs to provide a means for determining the locations of the frames in the bit stream being generated and outputted by the morph-link circuit 104-1 (e.g., the data 142) so that the morph-link circuit 104-2 can properly insert the frame markers back into the bit streams (e.g., into the streaming data 112).

In some embodiments, the streaming data 110 (and the streaming data 112) are formatted according to JESD protocols. In an example, the JESD protocols define a multi-block as 32 64-bit blocks, and the 32 64-bit blocks equate to 2048 bits, which equate to 256 bytes, which equate to 4 UCIe frames. A JESD multi-block thus includes 32 2-bit framing marker bits (or 32 2-bit sync bits), and these 32 2-bit framing marker bits can form 32-bit sideband commands/data associated with the multi-block data bits. As the size of the JESD multi-block is the same as 4 UCIe frames, the morph-link circuit 104-1 may separate (and/or generate) these sideband commands (e.g., data associated with the multi-block data bits) and transmit them to the interface circuit 106-1 (e.g., as the control information 120), and the interface circuit 106-1 may transmit these sideband commands over the sideband channel 114 (e.g., a UCIe sideband channel). In this way, the sideband channel 114 can be used to carry JESD's sideband commands and/or data associated with the multi-block data bits (e.g., JESD's in-band commands or JESD's forward error correction (FEC) information). Further, the morph-link circuit 104-1 may obtain and transmit, to the interface circuit 106-1, a vendor defined command carrying 32-bit JESD in-band command bits. As a UCIe sideband channel can carry 32-bit data packets, a UCIe sideband channel (e.g., the sideband channel 114) can be used to transmit the vendor defined command to carry the 32-bit JESD in-band command bits received from the morph-link circuit 104-1.

In some embodiments, the streaming data 110 includes one or more control bits for use with error correction. For example, the JESD protocols may define a forward error correction (FEC) coding method. As an example, for every 2048 bits, 26 additional bits (e.g., parity bits) can be added so that a total of 2074 bits is transmitted by the JESD interface (e.g., to the morph-link circuit 104-1). These 26 additional bits (parity bits) correspond to a 32-bit JESD in-band command. In some embodiments, the morph-link circuit 104-1 removes the 26 additional bits (parity bits) from the streaming data 110 and transmits the 26 additional bits (parity bits), separately from the data 142, to the interface circuit 106-1. The interface circuit 106-1 may transmit the 26 additional bits (parity bits), corresponding to a 32-bit JESD in-band command, using the sideband channel 114. For example, because a UCIe sideband channel can carry 32-bit data packets, a UCIe sideband channel can be used to transmit a vendor defined command used to carry JESD's FEC parity bits received from the morph-link circuit 104-1. Because the control signals, such as JESD's sideband commands/data associated with the multi-block data bits and parity bits, are transmitted using the sideband channel 114, the data rate for the data transmitted via the data lines 118 (e.g., the data 142) is not reduced.

In Figure 1A, the clock signals 130, 132, 134, and 136 may correspond to a particular clock rate or data rate. The streaming data 110 (and the streaming data 112) includes control bits (such as the framing markers), and the data 142 does not include such control bits; hence, the clock rate of the streaming data 110 (and the streaming data 112) may be at least slightly greater than the clock rate of the morph-link circuit 104-1. However, ignoring slight difference in rates, for Mode 1, in an example, a clock rate of the streaming data 110 (e.g., a clock rate of a signal converter circuit generating the streaming data 110) may be the same as a clock rate of the morph-link circuit 104-1. Further in an example, the clock rate of the morph-link circuit 104-1 (e.g., a clock rate of the clock signal 130) may be the same as the clock rate of the interface circuit 106-1 (e.g., a clock rate of the clock signal 132). The data rate of the morph-link circuit 104-1 may be the same as the data rate of the interface circuit 106-1. Similarly, the clock rate of the morph-link circuit 104-2 (e.g., a clock rate of the clock signal 136) may be the same as the clock rate of the interface circuit 106-2 (e.g., a clock rate of the clock signal 134). The data rate of the morph-link circuit 104-2 may be the same as the data rate of the interface circuit 106-2. For the foregoing examples, the clock rate may represent a composite clock rate, and the data rate may represent a composite data rate.

Figure 1B illustrates an example of the multi-die package of Figure 1A operating in Mode 2 in accordance with some embodiments. As mentioned above, Mode 2 may be selected when the composite sample data rate (bits/sec) of the streaming data 110 (and/or the morph-link circuit 104-1) is less than the composite data rate of the data 142 (and/or the interface circuit 106-1). In some embodiments, the morph-link circuit 104-1 may add dummy bits to the streaming data 110 to match the data rate used by the interface circuit 106-1. In the example of Figure 1B, the morph-link circuit 104-1 outputs a valid signal 150 to indicate which portions of the data 142 are valid. In some embodiments, the valid signal 150 is transmitted to the interface circuit 106-2 via the valid signal 116. In some embodiments, the interface circuit 106-2 transmits a valid signal 151 to the morph-link circuit 104-2 to indicate which portions of the data 142 are valid.

In some embodiments, the streaming data 110 (and the streaming data 112) is formatted according to JESD protocols and the data 142 is formatted according to UCIe protocols. The JESD protocols allow variable data rates, whereas the UCIe protocols have a set of predetermined data rates (e.g., 4, 8, 12, 16, 24, or 32 Gbps per lane). For the UCIe interface, one of the predetermined data rates is selected and used.

In an example, the streaming data 110 may be provided using 8 parallel lanes at 26 Gbps per lane, and the interface circuit 106-1 may be used to provide bit streams using 8 parallel lanes (e.g., the data lines 118) at 32 Gbps per lane. In this example, the morph-link circuit 104-1 may keep (or maintain) the control bits (e.g., 2-bit framing marker bits in the bit streams from the JESD interface) and/or add dummy bits (or filler bits) up to the selected composite UCIe data rate, as the composite UCIe data rate is higher than the composite JESD data rate. The morph-link circuit 104-1 can indicate which data (or bits) is valid data (valid bits), and which data (or bits) is invalid data (or invalid bits) using a validity indicator (e.g., the valid signal 150). In one or more examples, the data rate (e.g., the composite data rate) of the valid data from the morph-link circuit 104-1 matches the data rate (e.g., the composite data rate) of the streaming data 110. For example, the morph-link circuit 104-1 may provide a data validity indicator (or a validity indicator) per bit or per byte. As an example, the morph-link circuit 104-1 may indicate, for each byte (e.g., 8 bits) of the data 142, whether the corresponding byte is valid or invalid; however, the subject technology is not limited thereto. The morph-link circuit 104-1 may provide the validity indicators via a separate channel to the interface circuit 106-1 (as indicated by the valid signal 150 in Figure 1B). Therefore, in one or more aspects, the morph-link circuit 104-1 generates a "valid" signal to compensate for the rate difference between the streaming data 110 (e.g., from a JESD interface) and the interface circuit 106-1.

In some embodiments, the morph-link circuit 104-1 transmits to the interface circuit 106-1: (a) the data 142 (e.g., optionally including control bits and/or dummy bits), and (b) the validity indicators. The interface circuit 106-1 may transmit to the interface circuit 106-2: (a) the data 142 (e.g., including control bits and/or dummy bits) via the data lines 118 and (b) the validity indicators (received from the morph-link circuit 104-1) over a validity channel (e.g., as indicated by the valid signal 116). In some embodiments, the morph-link circuit 104-2 receives from the interface circuit 106-2: (a) the data 142 (e.g., including control bits and/or dummy bits) via the data lines 126, and (b) the validity indicators via a separate channel (as indicated by the valid signal 151). Using the validity indicators, the morph-link circuit 104-2 can determine which data (or bits) of the data 142 is valid or invalid, and remove invalid data (e.g., dummy bits) and then generate the streaming data 112 (without the dummy bits). In some embodiments, the control bits kept in the data 142 are considered to be valid, and are included in the streaming data 112 (whereas dummy bits are considered to be invalid and are removed).

In some embodiments, in Mode 2, the morph-link circuit 104-1 keeps at least a portion of the control bits from the streaming data 110 in the data 142 to compensate for the difference in data rates. For example, if the morph-link circuit 104-1 does not use other control bits (except for the validity indicators), then the data 142 and the validity indicators received by the morph-link circuit 104-2 contain all necessary data and control bits, and the sideband channel 114 need not be used.

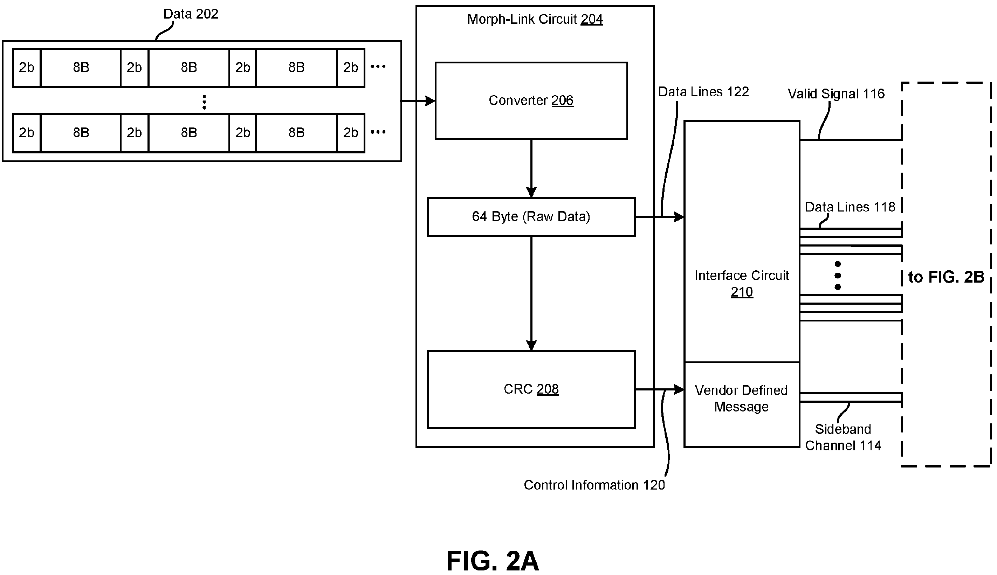

Figures 2A-2B illustrate an example operation of an example multi-die package in accordance with some embodiments. In the example of Figures 2A-2B, all of the control information received by the morph-link circuit 204 (e.g., the control information in data 202) is not transmitted to the interface circuit 210 and/or the interface circuit 250. For example, checksum information is generated from the control information in data 202, and the checksum information is transmitted to the interface circuit 210 and/or the interface circuit 250. In this way less control information is transmitted via the sideband channel 114. This is advantageous in circumstances in which a data rate for the control information in the data 202 exceeds a data rate for the sideband channel 114. In some embodiments, the data 202 is the same as the streaming data 110 in Figure 1A. In some embodiments, the interface circuit 210 is an instance of the interface circuit 106-1. In some embodiments, the interface circuit 250 is an instance of the interface circuit 106-2. In some embodiments, the morph-link circuit 254 is an instance of the interface circuit 104-2.

In some embodiments, the morph-link circuit 204: (i) receives the data 202 that includes control bits (e.g., framing markers); (ii) removes the control bits; (iii) calculates a checksum (e.g., a CRC) for the control bits; and (iv) transmits the data bits and the checksum to the interface circuit 210. In some embodiments, the morph-link circuit 204 is an instance of the morph-link circuit 104-1. In some embodiments, a morph-link circuit 104-1 is configurable to selectively compute (and transmit) a CRC of control bits from the streaming data, or forward the control bits from the streaming data 110. In some embodiments, after the morph-link circuit 104-1 receives the streaming data 110 (which includes framing markers), the morph-link circuit 104-1 removes the framing markers (e.g., 2-bit framing markers bits or 2-bit sync bits) and generates the data 142 (e.g., a bit stream in a UCIe raw streaming format). Thus, the data 142 is composed of raw streaming frames, but the starting/ending locations of such frames are not included in the data 142. However, the morph-link circuit 104-1 determines the starting/ending locations of such frames during this process.

In some embodiments, the morph-link circuit 204 includes a converter 206 configured to convert the data 202 to raw data (e.g., separate the control bits from the data bits). In some embodiments, the converter 206 is configured to insert dummy bits into the data 202. In some embodiments, the converter 206 comprises one or more counters and/or buffers (e.g., to identify and separate the control bits). In some embodiments, the morph-link circuit 204 includes a CRC component 208 configured to calculate a CRC (or checksum) from the data 202 (e.g., the control bits and/or raw data from the data 202).

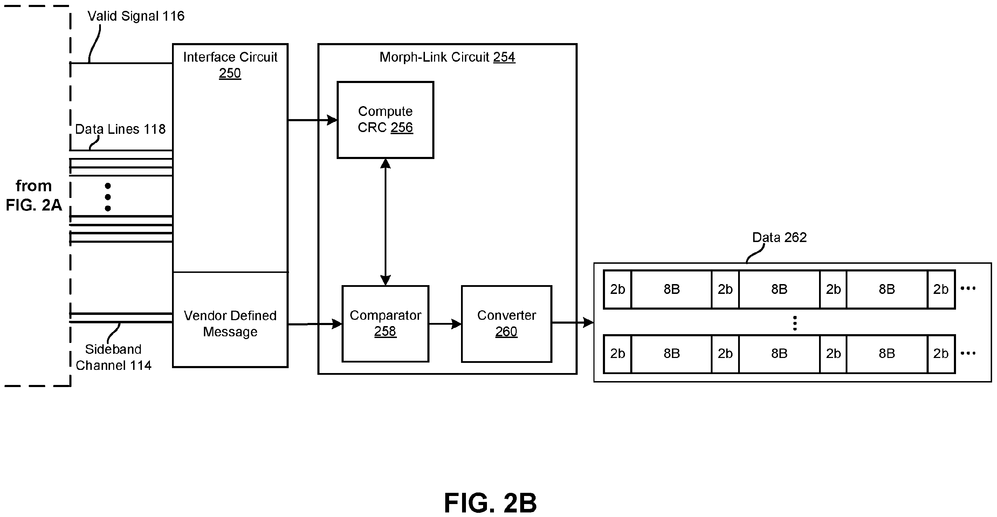

In some embodiments, the morph-link circuit 204 performs (or computes) a cyclic-redundancy-check (CRC) over a frame (e.g., a fixed-length frame) of the data 202 and produces the CRC result (e.g., a check-sum). The morph-link circuit 204 transmits the CRC result to the interface circuit 210 via a separate channel (e.g., as the control information 120) when the raw data (e.g., the data 142) is transmitted to the interface circuit 210 (e.g., via the data lines 122). In some embodiments, when the interface circuit 210 transmits the data 142 over the data lines 118, the interface circuit 210 also transmits the CRC result over the sideband channel 114. When the interface circuit 250 (Figure 2B) receives the data (bit stream) from the interface circuit 210, the interface circuit 250 also receives the CRC result over the sideband channel 114. After receiving the data and the CRC result from the interface circuit 250, the morph-link circuit 254 performs a CRC (which may be sometimes referred to as a second CRC) over each same fixed length frame of the received bit stream repeatedly while moving the starting/ending location of the frame boundary until the CRC result obtained by the morph-link circuit 254 matches the CRC result sent by the morph-link circuit 204. In this way, the starting/ending locations of the frames of the bit stream (or the frame boundary of the bit stream) can be recovered by the morph-link circuit 254. The morph-link circuit 254 may then insert the frame markers (e.g., 2-bit framing markers bits or 2-bit sync bits) into the received bit stream to generate the data 262 (e.g., a bit stream in a format supported by the JESD protocols). In some embodiments, the morph-link circuit 254 transmits the data 262 to a JESD interface.

In some embodiments, the morph-link circuit 254 includes a CRC component 256 configured to compute a CRC from the data received from the interface circuit 210 via the data lines 118 (e.g., the data 142). In some embodiments, the morph-link circuit 254 includes a comparator 258 configured to compare the CRC computed by the CRC component 256 with the CRC received from the interface circuit 210 via the sideband channel 114. In some embodiments, the comparator 258 transmits a signal to the CRC component 256 to indicate whether the CRCs match. In some embodiments, in accordance with the CRCs matching, the CRC component 256 signals a converter 260 to construct the data 262 using the raw data from the interface circuit 250 and inserting control bits indicating the frame boundary in accordance with the matching CRCs. In some embodiments, each morph-link circuit 104 includes the components of the morph-link circuit 204 and/or the morph-link circuit 254. For example, a morph-link circuit 104 may include a first set of (receiver) components for data received from an interface circuit (e.g., an interface circuit 106) and a second set of (transmitter) components for data to be sent to an interface circuit. In some embodiments, each die 102 comprises a transceiver configured to transmit and receive data via the respective interface circuits 106. For example, each interface circuit 106 includes components for, and is configured to, send and receive data via respective data lanes.

In an example, the fixed length of a frame may be a predetermined length (and thus known (or pre-programmed) to the morph-link circuits (e.g., the morph-link circuits 104) and/or the interface circuits (e.g., the interface circuits 106). In another example, the morph-link circuit 204 may select or determine the length of a frame, and transmit it to the interface circuit 210 (e.g., separately from the bit stream). The morph-link circuit 254 may obtain this information about the length of a frame via the interface circuit 250 and use it during the CRC process.

In one example, the CRC result generation by the morph-link circuit 204 and the CRC result checking by the morph-link circuit 254 are performed for every frame. In another example, the CRC result generation by the morph-link circuit 204 and the CRC result checking by the morph-link circuit 254 are not performed for every frame. For example, the CRC result generation/checking may repeat after a predetermined number of frames, or after a variable number of frames (where the number of frames may vary depending on a number of factors). Performing the CRC result generation/checking less often than every frame can impact the amount of time needed to detect whether the CRC results match or not (e.g., impacts the lock/unlock detection time). In some embodiments, the morph-link circuit 204 determines one or more CRC parameters (e.g., length and/or polynomial) (and optionally determines a frame size for the data) and transmits the one or more CRC parameters to the morph-link circuit 254 (e.g., prior to transmitting the data). In some embodiments, the morph-link circuits 204 and 254 communicate to determine the one or more CRC parameters and/or the frame size (e.g., as part of a handshaking procedure). In some embodiments, the one or more CRC parameters (and/or the frame size) are selected based on a bandwidth of the sideband channel 114.

In some embodiments, the morph-link circuit 204 receives a first clock signal (e.g., the clock signal 130, Figure 1A) and the interface circuit 210 receives a second clock signal (e.g., the clock signal 132, Figure 1A). The first clock signal and the second clock signal may or may not operate at the same clock rate and/or data rate. In some embodiments, the morph-link circuit 204 operates in Mode 1, Mode 2, or Mode 3 as described above with respect to the morph-link circuit 104-1.

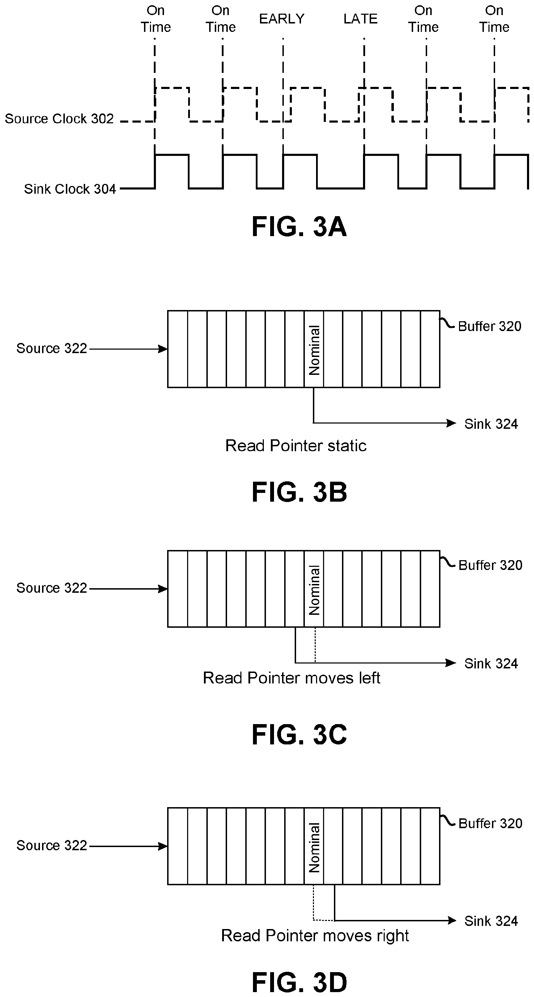

Figure 3A illustrates an example timing diagram of a source clock 302 and a sink (destination) clock 304 in accordance with some embodiments. The source clock 302 and a sink clock 304 may have the same average clock rate over time, but they may sometimes have offsets in their clock rates. For example, the sink clock 304 may sometimes arrive early and/or arrive late, as shown in Figure 3A. As an example, the source clock 302 may represent the clock signal 130 in Figure 1A, and the sink clock 304 may represent a clock signal 132 in Figure 1A. In another example, the source clock 302 may represent the clock signal 132, and the sink clock 304 may represent the clock signal 134. In yet another example, the source clock 302 may represent the clock signal 134, and the sink clock 304 may represent the clock signal 136. In yet another example, the source clock 302 may represent the clock signal 136, and the sink clock 304 may represent the clock signal 134. In one or more aspects, if the source clock 302 and the sink clock 304 are derived from different reference clocks (e.g., instead of the same reference clock), the offsets may be more often or greater in magnitude.

Figures 3B-3D illustrate example buffer operations for absorbing differences between source and sink clocks in accordance with some embodiments. In some embodiments, a morph-link circuit 104 (e.g., the morph-link circuit 104-1) includes a buffer 320. In some embodiments, the buffer 320 comprises first-in-first-out (FIFO) memory. In an example, the source 322 is a signal from a JESD interface (e.g., corresponding to the streaming data 110), and the sink 324 may represent the morph-link interface 104-1. In another example, the source 322 may represent the interface circuit 106-2, and the sink 324 may represent the morph-link circuit 104-2. As an example, the source 322 may write bits (or data) into the buffer 320, and the sink 324 may read bits (or data) from the buffer.

Referring to Figure 3B, when the source clock and the sink clock are substantially identical (e.g., derived from the same reference clock), the sink 324 may read data (or bits) from the same read location. This example corresponds to the "on time" sink clock 304 in Figure 3A.

Referring to Figure 3C, when a sink (read) clock is temporarily faster than a source (write) clock, the read location may be moved to the left. For example, a source (e.g., a JESD interface) may write bits into the buffer at the left, and a sink (e.g., a morph-link circuit 104) may read a bit(s) from a read location that is moved to the left. This example corresponds to the "early" sink clock 304 in Figure 3A.

Referring to Figure 3D, when a sink (read) clock is temporarily slower than a source (write) clock, the read location may be moved to the right. For example, a source may write bits into the buffer at the left, and a sink (e.g., a morph-link circuit 104) may read a bit(s) from a read location that is moved to the right. This example corresponds to the "late" sink clock 304 in Figure 3A.

As an example, Mode 1, described above, may have offsets in rates (e.g., offsets in clock rates between the clock signal 130 and the clock signal 132). In some embodiments, a buffer, such as the buffer 320 as shown with reference to Figures 3B-3D, is used for such a Mode 1.

In one or more aspects, a morph-link circuit may be sometimes referred to as a streaming adapter or an adapter circuit block.

In one or more aspects, a signal converter for a die 102 (described above but not shown) may represent a signal processor, a core circuit block, a digital signal processor block, one or more components that include a number of different electronic and/or optical components (such as an antenna, transmission/reception blocks, and/or processing blocks).

As used herein, a circuit block may include one or more controllers or one or more controller circuits. A circuit block may include circuits, having, for example, conductive traces, lines, pads, vias and/or transistors. A circuit block may also include firmware or operating parameters. The die 102-1 may include other circuit blocks (not shown) coupled to the signal converter. Similarly, the die 102-2 may include other circuit blocks (not shown) coupled to the signal converter. In another example, a signal converter may be a signal processor or some other electrical and/or optical components.

For example, referring to Figure 1A, a first entity may design the morph-link circuits 104 and the die 102-1. A second entity may design the die 102-2, employing the morph-link circuit 104-2 designed by the first entity. The morph-link circuits 104 may be designed in accordance with one or more aspects of the subject technology and may be designed to be interoperable with any one of various streaming data interfaces (e.g., not just a JESD interface) and designed to be interoperable with any one of various interconnect interfaces (e.g., not just a UCIe interface). In some embodiments, each morph-link circuit 104 is configurable for use with multiple streaming protocols and/or multiple interface circuits. For example, the particular streaming protocol is identified and the morph-link circuit 104 operates accordingly. In some embodiments, the morph-link circuit identifies the streaming protocol (e.g., based on control information). In some embodiments, the streaming protocol is programmed into and/or transmitted to the morph-link circuit 104. Hence, the morph-link circuits 104 may be universal or interoperable (not vendor defined and not limited to the specifications of any specific vendor).

In some embodiments, the dies 102-1 and 102-2 are mounted on a same substrate. In another example, the die 102-1 may be mounted on a first substrate (e.g., the bumps of a UCIe interface of the die 102-1 are attached to the first substrate), and die 102-2 may be mounted on a second substrate (e.g., the bumps of a UCIe interface of the die 102-2 are attached to the second substrate). Signals between the first substrate and the second substate may be transmitted and received using various components and methods (e.g., wired connections or wireless connections between the first and second substrates).

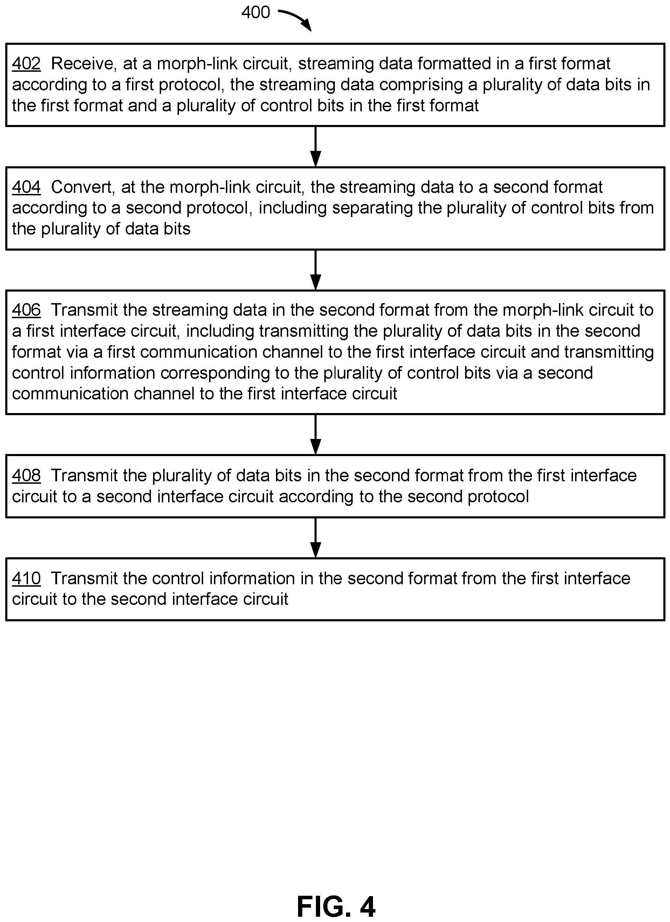

Figure 4 is a flow diagram illustrating a method 400 of operating a semiconductor device in accordance with some embodiments. The method 400 may be performed using a system (e.g., comprising one or more semiconductor dies or chiplets) having control circuitry and memory storing instructions for execution by the control circuitry. In some embodiments, the method 400 is performed by executing instructions stored in the memory of a computing system.

A morph-link circuit (e.g., the morph-link circuit 104-1) receives (402) streaming data (e.g., the streaming data 110) formatted in a first format according to a first protocol (e.g., a JESD protocol), the streaming data comprising a plurality of data bits in the first format and a plurality of control bits in the first format. In some embodiments, the streaming data is received from an interface circuit (e.g., a JESD interface circuit).

The morph-link circuit converts (404) the streaming data to a second format according to a second protocol (e.g., a UCIe protocol), including separating the plurality of control bits from the plurality of data bits. In some embodiments, converting the streaming data to the second format comprises generating raw data (e.g., 64-byte raw data). In some embodiments, the morph-link circuit uses a converter component to convert the streaming data.

The morph-link circuit transmits (406) the streaming data in the second format (e.g., the data 142) to a first interface circuit (e.g., the interface circuit 106-1), including transmitting the plurality of data bits in the second format via a first communication channel (e.g., the data lines 122) to the first interface circuit and transmitting control information corresponding to the plurality of control bits (e.g., the control information 120) via a second communication channel to the first interface circuit.

The first interface circuit transmits (408) the plurality of data bits in the second format to a second interface circuit (e.g., the interface circuit 106-2) according to the second protocol. In some embodiments, the plurality of data bits are transmitted via a set of data lines (e.g., the data lines 118).

The first interface circuit transmits (410) the control information in the second format to the second interface circuit (e.g., via the sideband channel 114). In some embodiments, the control information is transmitted concurrently (e.g., in parallel) with the plurality of data bits. Although Figure 4 illustrates a number of logical stages in a particular order, stages which are not order dependent may be reordered and other stages may be combined or broken out. Some reordering or other groupings not specifically mentioned will be apparent to those of ordinary skill in the art, so the ordering and groupings presented herein are not exhaustive. Moreover, it should be recognized that the stages could be implemented in hardware, firmware, software, or any combination thereof.

Turning now to some example embodiments. Various examples and aspects of the present disclosure are described below. These are provided as examples, and do not limit the scope of the present disclosure.

(A1) In one aspect, some embodiments include a device (e.g., a semiconductor device), comprising a first semiconductor die (e.g., the die 102-1) including a morph-link circuit (e.g., the morph-link circuit 104-1 or the morph-link circuit 204) and a first interface circuit (e.g., the interface circuit 106-1 or the interface circuit 210). The morph-link circuit is configured to: (i) receive streaming data (e.g., the streaming data 110) formatted in a first format according to a first protocol, the streaming data comprising a plurality of data bits in the first format and a plurality of control bits in the first format; (ii) convert the streaming data to a second format according to a second protocol, including separating the plurality of control bits from the plurality of data bits; and (iii) transmit the streaming data in the second format (e.g., the data 142) to the first interface circuit. In some embodiments, the morph-link circuit is further configured to transmit the plurality of data bits in the second format via a first communication channel (e.g., the data lines 122) to the first interface circuit, and to transmit control information corresponding to the plurality of control bits via a second communication channel to the first interface circuit. In some embodiments, the first interface circuit is configured to cause: (a) transmitting the plurality of data bits in the second format to a second interface circuit disposed outside the first semiconductor die according to the second protocol; and (b) transmitting, separately from the plurality of data bits in the second format, the control information in the second format to the second interface circuit according to the second protocol. The second protocol is different from the first protocol and the second communication channel is separate and different from the first communication channel. For example, the streaming data may be formatted according to the JESD 204 standard. As a particular example, the plurality of data bits may consist of 64 bits and the plurality of control bits may consist of 2 synchronization bits. In some embodiments, the second protocol corresponds to a universal chiplet interconnect express (UCIe) standard. For example, the first interface circuit may be configured for an advanced UCIe interface or a standard UCIe interface.

(A2) In some embodiments of A1, transmitting the plurality of data bits in the second format to the second interface circuit comprises transmitting the plurality of data bits in the second format over a plurality of data lines (e.g., the data lines 118) in a parallelized manner without framing overhead according to the second protocol. In some embodiments, the plurality of data bits are transmitted to the second interface circuit via a bridge or interposer component.

(A3) In some embodiments of A1 or A2, transmitting the control information in the second format to the second interface circuit comprises transmitting the control information in the second format to the second interface circuit via a sideband communication channel (e.g., the sideband channel 114), where the sideband communication channel is separate and different from one or more channels for transmitting the plurality of data bits in the second format to the second interface circuit. For example, no control signals are transmitted via the main channel (e.g., the high-speed data lines). In some embodiments, the control information is transmitted as a vendor defined message in the second protocol.

(A4) In some embodiments of any of A1-A3, transmitting the control information in the second format to the second interface circuit comprises transmitting at least a subset of the plurality of control bits. In some embodiments, the plurality of control bits includes one or more parity bits.

(A5) In some embodiments of any of A1-A4, transmitting the control information in the second format to the second interface circuit comprises transmitting checksum data for the streaming data (e.g., as described above with reference to Figures 2A-2B).

(A6) In some embodiments of any of A1-A5, the morph-link circuit is further configured to generate the control information by performing a cyclic redundancy check (CRC) of the plurality of data bits (e.g., using the CRC component 208).

(A7) In some embodiments of any of A1-A6, the streaming data formatted according to the first protocol comprises the plurality of data bits in the first format interleaved with the plurality of control bits in the first format.

(A8) In some embodiments of any of A1-A7, the device further comprising a second semiconductor die (e.g., the die 102-2) that includes the second interface circuit (e.g., the interface circuit 106-2) and a second morph-link circuit (e.g., the morph-link circuit 104-2).

(A9) In some embodiments of A8, the second morph-link circuit is configured to convert the streaming data from the second format to the first format (e.g., represented by the streaming data 112) using the control information.

(A10) In some embodiments of A9, the second morph-link circuit configured to convert the streaming data from the second format to the first format is further configured to generate one or more control bits (e.g., using the converter 260). For example, synchronization bits are generated based on an identified frame boundary and then streamed with the data bits in the streaming data in the first format.

(A11) In some embodiments of any of A8-A10, the second morph-link circuit is configured to: (i) compute a CRC for the streaming data in the second format over a fixed-length frame (e.g., using the CRC component 256); (ii) compare the CRC to a source CRC in the control information (e.g., using the comparator 258); and (iii) identify a boundary in the plurality of data bits in the second format in response to the CRC matching the source CRC. In some embodiments the second morph-link circuit is configured to repeat computing a CRC, comparing a CRC and identifying a boundary for some frames but not for other frames. In some embodiments, parameters of the CRC are shared between the morph-link circuit and the second morph-link circuit (e.g., communicated directly or via a control component). In some embodiments, the CRC size corresponds to a frame size in the streaming data.

(A12) In some embodiments of any of A1-A11: (i) the morph-link circuit is configured to receive the streaming data in the first format at a first data rate (e.g., corresponding to the clock signal 130); (ii) the first interface circuit is configured to cause transmitting the plurality of data bits in the second format at a second data rate (e.g., corresponding to the clock signal 132), the second data rate being greater than the first data rate by a rate difference; and (iii) the morph-link circuit is configured to compensate for the rate difference by: (a) transmitting dummy bits to the first interface circuit; and (b) transmitting a valid signal (e.g., the valid signal 150) to the first interface circuit via a separate channel, the valid signal indicating which bits are dummy bits. In this way, the valid data bits are transmitted by the first interface circuit at the first data rate while the first interface circuit continues to operate at the second data rate. In some embodiments, a second morph-link circuit (e.g., in the receiver die) is configured to remove the dummy bits from the data using the valid signal (e.g., to generate the streaming data 112).

(A13) In some embodiments of any of A1-A12: (i) the morph-link circuit is configured to receive the streaming data in the first format at a variable data rate; (ii) the first interface circuit is configured to cause transmitting the plurality of data bits in the second format at a second data rate; and (iii) the morph-link circuit is configured to: (a) transmit a variable number of dummy bits to the first interface circuit, the variable number of dummy bits corresponding to a rate difference between the variable data rate and the second data rate; and (b) transmit a valid signal to the first interface circuit, the valid signal indicating which bits are dummy bits.

(A14) In some embodiments of any of A1-A13, the morph-link circuit comprises a buffer circuit (e.g., the buffer 320) configured to compensate for clock differences between a first clock signal (e.g., the clock signal 130) for being utilized to provide the streaming data in the first format to the morph-link circuit and a second clock signal (e.g., the clock signal 132) for being utilized by the first interface circuit for transmitting the plurality of data bits in the second format. For example, the buffer may be a first in first out (FIFO) buffer. In some embodiments, the buffer is configured to store the streaming data prior to transmission to the first interface circuit. As an example, the buffer may be used to absorb small rate variations and/or drift of clock edges between the two clock signals.

(A15) In some embodiments of any of A1-A14, the morph-link circuit is configured to receive the streaming data in the first format at a first data rate, and the first interface circuit is configured to cause transmitting the plurality of data bits in the second format at the first data rate. For example, the streaming data is received in a multi-block (e.g., 32 64b blocks) and the first interface circuits transmits the streaming data as 4 corresponding frames.

(A16) In some embodiments of any of A1-A15: (i) the morph-link circuit is configured to operate in accordance with a first clock signal, (ii) the first interface circuit is configured to operate in accordance with a second clock signal, and (iii) a rate of the first clock signal is less than a rate of the second clock signal. In some embodiments, the morph-link circuit and the first interface circuit are configured to operate in accordance with a same clock signal. For example, the morph-link circuit and the first interface circuit receive a same clock, or receive respective clocks derived from a same clock.

(A17) In some embodiments of any of A1-A16, the morph-link circuit configured to convert the streaming data to the second format is further configured to convert the streaming data in the first format comprising a plurality of parallel bit streams into the streaming data in the second format comprising one or more byte streams. For example, the morph-link is configured to convert 8 parallel bit streams (e.g., 64 bits from each) into a byte stream (64 bytes per frame).

(B1) In another aspect, some embodiments include a method (e.g., the method 400) of operating a semiconductor device. The method includes: (i) receiving, at an morph-link circuit, streaming data formatted in a first format according to a first protocol, the streaming data comprising a plurality of data bits in the first format and a plurality of control bits in the first format; (ii) converting, at the morph-link circuit, the streaming data to a second format according to a second protocol, including separating the plurality of control bits from the plurality of data bits; (iii) transmitting the streaming data in the second format from the morph-link circuit to a first interface circuit, including transmitting the plurality of data bits in the second format via a first communication channel to the first interface circuit and transmitting control information corresponding to the plurality of control bits via a second communication channel to the first interface circuit; (iv) transmitting the plurality of data bits in the second format from the first interface circuit to a second interface circuit according to the second protocol; and (v) transmitting the control information in the second format from the first interface circuit to the second interface circuit. In some embodiments, the second protocol is different from the first protocol. In some embodiments, the second communication channel is separate and different from the first communication channel.

(C1) In another aspect, some embodiments include a semiconductor device, comprising a first semiconductor die including a morph-link circuit and a first interface circuit. The morph-link circuit is configured to: (i) receive streaming data formatted in a first format according to a first protocol, the streaming data comprising a plurality of data bits in the first format and a plurality of control bits in the first format; (ii) convert the streaming data to a second format according to a second protocol, including separating the plurality of control bits from the plurality of data bits; and (iii) transmit the streaming data in the second format to the first interface circuit. In some embodiments, the morph-link circuit is further configured to transmit the plurality of data bits in the second format via a first communication channel to the first interface circuit, and to transmit control information in the second format corresponding to the plurality of control bits via a second communication channel to the first interface circuit. In some embodiments, the first interface circuit is configured to cause: (a) transmitting the plurality of data bits in the second format to a second interface circuit disposed outside the first semiconductor die according to the second protocol; and (b) transmitting, separately from the plurality of data bits in the second format, the control information in the second format to the second interface circuit according to the second protocol, where the second protocol is different from the first protocol and the second communication channel is separate and different from the first communication channel. In some embodiments, the first format comprises a bit stream format, the second format comprises a byte stream format, the streaming data in the first format comprises a plurality of parallel bit streams, and the plurality of data bits in the second format comprise a byte stream. In some embodiments, the morph-link circuit is configured to transmit a validity indicator to the first interface circuit, the validity indicator being separate from the plurality of data bits in the second format and the control information in the second format. In some embodiments, the first interface circuit is configured to cause transmitting, separately from the plurality of data bits in the second format and the control information in the second format, the validity indicator indicating whether the byte stream is valid. In some embodiments, a clock rate of the morph-link circuit is less than a clock rate of the first interface circuit, and the morph-link circuit is configured to: (i) add one or more dummy bits to the plurality of data bits in the second format; (ii) transmit the plurality of data bits in the second format including the one or more dummy bits to the first interface circuit; and (iii) transmit a valid signal to the first interface circuit, the valid signal indicating whether bits are dummy bits.

In one or more aspects, a lane may sometimes refer to a channel or a line, and vice versa. In one or more aspects, a bit may represent one bit, one or more bits, or a plurality of bits. In one or more aspects, a bit stream may represent one bit stream, one or more bit streams, or a plurality of bit streams. In one or more aspects, the term outputting and the like may refer to transmitting and the like, and vice versa. The term inputting and the like may refer to receiving and the like, and vice versa.

While the subject technology is described with one or more examples (e.g., a specific number of dies, a specific number of modules, a specific number of areas, a specific number of channels), these are examples, and the subject technology is not limited thereto.

In one or more implementations, not all of the depicted components in each figure may be required, and one or more implementations may include additional components not shown in a figure. Variations in the arrangement and type of the components may be made without departing from the scope of the subject disclosure. Additional components, different components, or fewer components may be utilized within the scope of the subject disclosure.

In one or more aspects, the phrase "bit stream" when used to describe data generated, transmitted or output by the morph-link circuit 104-1 (or 204) may be in a form of "byte stream," and hence such "bit stream" may be referred to as "byte stream." Similarly, in one or more aspects, the phrase "bit stream" when used to describe data received, generated, transmitted or output by the interface circuit 106-1 (or 210) or by the interface circuit 106-2 (250) may be in a form of "byte stream," and hence such "bit stream" may be referred to as "byte stream." Similarly, in one or more aspects, the phrase "bit stream" when used to describe data received by the morph-link circuit 104-2 (or 254) from the interface circuit 106-2 (250) may be in a form of "byte stream," and hence such "bit stream" may be referred to as "byte stream."

In one or more examples, a reference numeral without a dash (e.g., 102; 104; 106) may refer to one or more same reference numerals with a dash (e.g., 102-1, 102-2; 104-1, 104-2; 106-1, 106-2).

Headings and subheadings, if any, are used for convenience only and do not limit the invention. The word "exemplary" is used to mean serving as an example or illustration. Any implementation described herein as an "example" is not necessarily to be construed as preferred or advantageous over other implementations. Relational terms such as first and second and the like may be used simply for ease of understanding without necessarily requiring or implying any actual relationship or order between elements or actions and without necessarily requiring or implying that they have different characteristics unless stated otherwise.

Phrases such as an aspect, the aspect, another aspect, some aspects, one or more aspects, an implementation, the implementation, another implementation, some implementations, one or more implementations, an embodiment, the embodiment, another embodiment, some embodiments, one or more embodiments, a configuration, the configuration, another configuration, some configurations, one or more configurations, the subject technology, the disclosure, the present disclosure, other variations thereof and alike are for convenience and do not imply that a disclosure relating to such phrase(s) is essential to the subject technology or that such disclosure applies to all configurations of the subject technology. A disclosure relating to such phrase(s) may apply to all configurations, or one or more configurations. A disclosure relating to such phrase(s) may provide one or more examples. A phrase such as an aspect or some aspects may refer to one or more aspects and vice versa, and this applies similarly to other foregoing phrases.

A phrase "at least one of' preceding a series of items, with the terms "and" or "or" to separate any of the items, modifies the list as a whole, rather than each member of the list. The phrase "at least one of' does not require selection of at least one item; rather, the phrase allows a meaning that includes at least one of any one of the items, and/or at least one of any combination of the items, and/or at least one of each of the items. By way of example, each of the phrases "at least one of A, B, and C" and "at least one of A, B, or C" may refer to only A, only B, or only C; any combination of A, B, and C; and/or at least one of each of A, B, and C.

Further, at least one of a plurality of elements can represent (i) one element of the plurality of elements, (ii) some elements of the plurality of elements, or (iii) all elements of the plurality of elements. Further, "at least some," "at least some portions," "at least some parts," "at least a portion," "at least one or more portions," "at least a part," "at least one or more parts," "at least some elements," "one or more," or the like of a plurality of elements can represent (i) one element of the plurality of elements, (ii) a portion (or a part) of the plurality of elements, (iii) one or more portions (or parts) of the plurality of elements, (iv) multiple elements of the plurality of elements, or (v) all of the plurality of elements. Moreover, "at least some," "at least some portions," "at least some parts," "at least a portion," "at least one or more portions," "at least a part," "at least one or more parts," or the like of an element can represent (i) a portion (or a part) of the element, (ii) one or more portions (or parts) of the element, or (iii) the element, or all portions of the element.

The expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C. Furthermore, an expression "element A/element B" may be understood as element A and/or element B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two.

In one or more aspects, the terms "each other" and "one another" may be used interchangeably simply for convenience unless stated otherwise. For example, an expression "different from each other" may be understood as being different from one another. In another example, an expression "different from one another" may be understood as being different from each other. In one or more examples, the number of elements involved in the foregoing expression may be two. In one or more examples, the number of elements involved in the foregoing expression may be more than two.

Features of various embodiments of the present disclosure may be partially or wholly coupled to or combined with each other and may be variously inter-operated, linked or driven together. The embodiments of the present disclosure may be carried out independently from each other or may be carried out together in a co-dependent or related relationship. In one or more aspects, the components of each apparatus according to various embodiments of the present disclosure are operatively coupled and configured.

Unless otherwise defined, the terms (including technical and scientific terms) used herein have the same meaning as commonly understood by one of ordinary skill in the art to which example embodiments belong. It is further understood that terms, such as those defined in commonly used dictionaries, should be interpreted as having a meaning that is, for example, consistent with their meaning in the context of the relevant art and should not be interpreted in an idealized or overly formal sense unless expressly defined otherwise herein.

In one aspect, the blocks or components described in this present disclosure may be implemented in circuits or integrated circuits. A circuit or an integrated circuit may include one or more transistors.

In one or more aspects, a transistor may include one or more bipolar junction transistors (BJTs), which may refer to any of a variety of multi-terminal transistors operating on the principal of carrying current using both electrons and holes, including, but not limited to, an n-p-n BJT (NPN BJT) and a p-n-p BJT (PNP BJT).

In one or more aspects, transistors may include one or more field effect transistors (FETs), which may refer to any of a variety of multi-terminal transistors operating on the principals of controlling an electric field to control the shape and hence the conductivity of a channel of one type of charge carrier in a semiconductor material, including, but not limited to, a metal oxide semiconductor field effect transistor (MOSFET), a junction FET (JFET), a metal semiconductor FET (MESFET), a high electron mobility transistor (HEMT), a modulation doped FET (MODFET), an insulated gate bipolar transistor (IGBT), a fast reverse epitaxial diode FET (FREDFET), and an ion-sensitive FET (ISFET). A MOSFET may be an n-type MOSFET (NMOS) or a p-type MOSFET (PMOS). A complementary metal-oxide semiconductor (CMOS) device may include an NMOS and a PMOS.

In one or more aspects, transistors may include one or more BJTs and FETs. In one or more examples, transistors may include one or more BJTs and one or more CMOS devices, which may be referred to as Bi-CMOS devices.

Unless otherwise mentioned, various configurations described in the present disclosure may be implemented on a silicon, silicon-germanium (SiGe), gallium arsenide (GaAs), indium phosphide (InP) or indium gallium phosphide (InGaP) substrate, or any other suitable substrate. In one aspect, the terms base, emitter, and collector may refer to three terminals of a transistor and may refer to a base, an emitter and a collector of a bipolar junction transistor or may refer to a gate, a source, and a drain of a field effect transistor, respectively, and vice versa. In another aspect, the terms gate, source, and drain may refer to base, emitter, and collector of a transistor, respectively, and vice versa. In some aspects, a source and a drain may be used interchangeably. In describing a positional relationship, where the positional relationship between two parts is described, for example, using "on," "over," "under," "above," "below," "beneath," "near," "close to," or "adjacent to," "beside," "next to," or the like, one or more other parts may be located between the two parts unless a more limiting term, such as "immediate(ly)," "direct(ly)," or "close(ly)," is used. For example, when a structure is described as being positioned "on," "over," "under," "above," "below," "beneath," "near," "close to," or "adjacent to," "beside," or "next to" another structure, this description should be construed as including a case in which the structures contact each other as well as a case in which one or more additional structures are disposed or interposed therebetween. Furthermore, the terms "front," "rear," "back," "left," "right," "top," "bottom," "downward," "upward," "upper," "lower," "up," "down," "column," "row," "vertical," "horizontal," and the like refer to an arbitrary frame of reference.

It is understood that the specific order or hierarchy of steps, operations, or processes disclosed is an illustration of example approaches. Unless explicitly stated otherwise, it is understood that the specific order or hierarchy of steps, operations, or processes may be performed in different order, with the exception of steps and/or operations necessarily occurring in a particular order. Some of the steps, operations, or processes may be performed simultaneously. The accompanying method claims, if any, present elements of the various steps, operations or processes in a sample order, and are not meant to be limited to the specific order or hierarchy presented. These may be performed in serial, linearly, in parallel or in different order. It should be understood that the described instructions, operations, and systems can generally be integrated together in a single software/hardware product or packaged into multiple software/hardware products.

In describing a temporal relationship, when the temporal order is described as, for example, "after," "subsequent," "next," "before," "preceding," "prior to," or the like, a case that is not consecutive or not sequential may be included unless a more limiting term, such as "just," "immediate(ly)," or "direct(ly)," is used.

It is understood that, although the term "first," "second," or the like may be used herein to describe various elements, these elements should not be limited by these terms. These terms are only used to distinguish one element from another. For example, a first element could be a second element, and, similarly, a second element could be a first element, without departing from the scope of the present disclosure. Furthermore, the first element, the second element, and the like may be arbitrarily named according to the convenience of those skilled in the art without departing from the scope of the present disclosure.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

A phrase "substantially the same" or "nearly the same" may indicate a degree of being considered as being equivalent to each other taking into account minute differences due to errors in the manufacturing process.

The expression that an element (e.g., layer, film, component, die, circuit, transistor, channel, interconnect, interface, section, member, part, region, area, portion, or the like) "is engaged" with another element may be understood, for example, as that the element may be either directly or indirectly engaged with the another element. The term "is engaged" or similar expressions may refer to a term such as "covers," "surrounds," "is in contact," "overlaps," "crosses," "intersects," "is connected," "is coupled," "is attached," "is adhered," "is combined," "is linked," "is provided," "is disposed," "interacts," or the like. The engagement may involve one or more intervening elements disposed or interposed between the element and the another element, unless otherwise specified. Further, the element may be engaged at least partially or entirely with the another element, unless otherwise specified. Further, the element may be included in at least one of two or more elements that are engaged with each other. Similarly, the another element may be included in at least one of two or more elements that are engaged with each other. When the element is engaged with the another element, at least a portion of the element may be engaged with at least a portion of the another element. The term "with another element" or similar expressions may be understood as "another element," or "with, to, in, or on another element," as appropriate by the context. Similarly, the term "with each other" may be understood as "each other," or "with, to, or on each other," as appropriate by the context.

The phrase "through" may be understood, for example, to be at least partially through or entirely through.

The disclosure is provided to enable any person skilled in the art to practice the various aspects described herein. In some instances, when a detailed description of well-known functions or configurations may unnecessarily obscure aspects of the present disclosure, the detailed description thereof may be omitted. The disclosure provides various examples of the subject technology, and the subject technology is not limited to these examples. Various modifications to these aspects will be readily apparent to those skilled in the art, and the principles described herein may be applied to other aspects.

Unless stated otherwise, like reference numerals may refer to like elements throughout even when they are shown in different drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

The shapes, sizes, areas, ratios, numbers, and the like disclosed in the drawings for describing implementations of the present disclosure are merely examples, and thus, the present disclosure is not limited to the illustrated details.

When the term "comprise," "have," "include," "contain," "constitute," or the like is used, one or more other elements may be added unless a term such as "only" or the like is used. The terms used in the present disclosure are merely used in order to describe particular embodiments, and are not intended to limit the scope of the present disclosure. The terms used herein are merely used in order to describe example embodiments, and are not intended to limit the scope of the present disclosure. The terms of a singular form may include plural forms unless the context clearly indicates otherwise. An element proceeded by "a," "an," "the," or "said" does not, without further constraints, preclude the existence of additional elements.

The terms such as a "line" or "direction" should not be interpreted only based on a geometrical relationship in which the respective lines or directions are parallel or perpendicular to each other, and may be meant as lines or directions having wider directivities within the range within which the components of the present disclosure can operate functionally.

In one or more aspects, an element, feature, or corresponding information (e.g., a level, range, dimension, size, or the like) is construed as including an error or tolerance range even where no explicit description of such an error or tolerance range is provided. An error or tolerance range may be caused by various factors (e.g., process factors, internal or external impact, or the like). Furthermore, while the subject disclosure may provide many example ranges and values, these are non-limiting examples, and other ranges and values are within the scope of the subject technology.

All structural and functional equivalents to the elements of the various aspects described throughout the disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed under the provisions of 35 U.S.C. §112, sixth paragraph, unless the element is expressly recited using the phrase "means for" or, in the case of a method claim, the element is recited using the phrase "step for."

The title, background, brief description of the drawings, abstract, and drawings are hereby incorporated into the disclosure and are provided as illustrative examples of the disclosure, not as restrictive descriptions. It is submitted with the understanding that they will not be used to limit the scope or meaning of the claims. In addition, in the detailed description, it can be seen that the description provides illustrative examples, and the various features are grouped together in various implementations for the purpose of streamlining the disclosure. The method of disclosure is not to be interpreted as reflecting an intention that the claimed subject matter requires more features than are expressly recited in each claim. Rather, as the claims reflect, inventive subject matter lies in less than all features of a single disclosed configuration or operation. The claims are hereby incorporated into the detailed description, with each claim standing on its own as a separately claimed subject matter.

The claims are not intended to be limited to the aspects described herein, but are to be accorded the full scope consistent with the language claims and to encompass all legal equivalents. Notwithstanding, none of the claims are intended to embrace subject matter that fails to satisfy the requirements of the applicable patent law, nor should they be interpreted in such a way.

The foregoing description, for purposes of explanation, has been described with reference to specific embodiments. However, the illustrative discussions above are not intended to be exhaustive or limit the claims to the precise forms disclosed. Many modifications and variations are possible in view of the above teachings. The embodiments were chosen and described in order to best explain principles of operation and practical applications, to thereby enable others skilled in the art.

Further embodiments of the invention are described in the following in the form of concepts/clauses.
1. A method of operating a semiconductor device, the method comprising:
   receiving, at a morph-link circuit, streaming data formatted in a first format according to a first protocol, the streaming data comprising a plurality of data bits in the first format and a plurality of control bits in the first format;
   converting, at the morph-link circuit, the streaming data to a second format according to a second protocol, including separating the plurality of control bits from the plurality of data bits; and
   transmitting the streaming data in the second format from the morph-link circuit to a first interface circuit, including transmitting the plurality of data bits in the second format via a first communication channel to the first interface circuit and transmitting control information corresponding to the plurality of control bits via a second communication channel to the first interface circuit;
   transmitting the plurality of data bits in the second format from the first interface circuit to a second interface circuit according to the second protocol; and
   transmitting the control information in the second format from the first interface circuit to the second interface circuit,
   wherein the second protocol is different from the first protocol, and
   wherein the second communication channel is separate and different from the first communication channel.
2. A semiconductor device, comprising:
   a first semiconductor die including a morph-link circuit and a first interface circuit,
   wherein the morph-link circuit is configured to:
      receive streaming data formatted in a first format according to a first protocol, the streaming data comprising a plurality of data bits in the first format and a plurality of control bits in the first format;
      convert the streaming data to a second format according to a second protocol, including separating the plurality of control bits from the plurality of data bits; and
      transmit the streaming data in the second format to the first interface circuit,
   wherein the morph-link circuit, configured to transmit the streaming data, is further configured to transmit the plurality of data bits in the second format via a first communication channel to the first interface circuit, and to transmit control information in the second format corresponding to the plurality of control bits via a second communication channel to the first interface circuit,
   wherein the first interface circuit is configured to cause:
      transmitting the plurality of data bits in the second format to a second interface circuit disposed outside the first semiconductor die according to the second protocol; and
      transmitting, separately from the plurality of data bits in the second format, the control information in the second format to the second interface circuit according to the second protocol,
   wherein the second protocol is different from the first protocol,
      wherein the second communication channel is separate and different from the first communication channel,
      wherein the first format comprises a bit stream format, the second format comprises a byte stream format, the streaming data in the first format comprises a plurality of parallel bit streams, and the plurality of data bits in the second format comprise a byte stream,
      wherein the morph-link circuit is configured to transmit a validity indicator to the first interface circuit, the validity indicator being separate from the plurality of data bits in the second format and the control information in the second format,
      wherein the first interface circuit is configured to cause transmitting, separately from the plurality of data bits in the second format and the control information in the second format, the validity indicator indicating whether the byte stream is valid,
      wherein a clock rate of the morph-link circuit is less than a clock rate of the first interface circuit, and
      wherein the morph-link circuit is configured to:
         add one or more dummy bits to the plurality of data bits in the second format;
         transmit the plurality of data bits in the second format including the one or more dummy bits to the first interface circuit; and
         transmit a valid signal to the first interface circuit, the valid signal indicating whether bits are dummy bits.

## Claims

1. A semiconductor device, comprising:
a first semiconductor die including a morph-link circuit and a first interface circuit,
wherein the morph-link circuit is configured to:
receive streaming data formatted in a first format according to a first protocol, the streaming data comprising a plurality of data bits in the first format and a plurality of control bits in the first format;
convert the streaming data to a second format according to a second protocol, including separating the plurality of control bits from the plurality of data bits; and
transmit the streaming data in the second format to the first interface circuit,
wherein the morph-link circuit, configured to transmit the streaming data, is further configured to transmit the plurality of data bits in the second format via a first communication channel to the first interface circuit, and to transmit control information corresponding to the plurality of control bits via a second communication channel to the first interface circuit,
wherein the first interface circuit is configured to cause:
transmitting the plurality of data bits in the second format to a second interface circuit disposed outside the first semiconductor die according to the second protocol; and
transmitting, separately from the plurality of data bits in the second format, the control information in the second format to the second interface circuit according to the second protocol,
wherein the second protocol is different from the first protocol, and
wherein the second communication channel is separate and different from the first communication channel.

2. The semiconductor device of claim 1, wherein transmitting the plurality of data bits in the second format to the second interface circuit comprises transmitting the plurality of data bits in the second format over a plurality of data lines in a parallelized manner without framing overhead according to the second protocol.

3. The semiconductor device of one of the previous claims, wherein transmitting the control information in the second format to the second interface circuit comprises transmitting the control information in the second format to the second interface circuit via a sideband communication channel, and
wherein the sideband communication channel is separate and different from one or more channels for transmitting the plurality of data bits in the second format to the second interface circuit.

4. The semiconductor device of one of the previous claims, wherein transmitting the control information in the second format to the second interface circuit comprises transmitting at least a subset of the plurality of control bits.

5. The semiconductor device of one of the previous claims, wherein transmitting the control information in the second format to the second interface circuit comprises transmitting checksum data for the streaming data.

6. The semiconductor device of one of the previous claims, wherein the morph-link circuit is further configured to generate the control information by performing a cyclic redundancy check (CRC) of the plurality of data bits.

7. The semiconductor device of one of the previous claims, wherein the streaming data formatted according to the first protocol comprises the plurality of data bits in the first format interleaved with the plurality of control bits in the first format.

8. The semiconductor device of one of the previous claims, further comprising a second semiconductor die that includes the second interface circuit and a second morph-link circuit.

9. The semiconductor device of claim 8, wherein the second morph-link circuit is configured to convert the streaming data from the second format to the first format using the control information.

10. The semiconductor device of one of claims 8 or 9, wherein the second morph-link circuit configured to convert the streaming data from the second format to the first format is further configured to generate one or more control bits.

11. The semiconductor device of one of claims 8 to 10, wherein the second morph-link circuit is configured to:
compute a CRC for the streaming data in the second format over a fixed-length frame;
compare the CRC to a source CRC in the control information; and
identify a boundary in the plurality of data bits in the second format in response to the CRC matching the source CRC, and
wherein the second morph-link circuit is configured to repeat computing a CRC, comparing a CRC and identifying a boundary for some frames but not for other frames.

12. The semiconductor device of one of the previous claims, wherein:
the morph-link circuit is configured to receive the streaming data in the first format at a first data rate;
the first interface circuit is configured to cause transmitting the plurality of data bits in the second format at a second data rate, the second data rate being greater than the first data rate by a rate difference; and
the morph-link circuit is configured to compensate for the rate difference by:
transmitting dummy bits to the first interface circuit; and
transmitting a valid signal to the first interface circuit via a separate channel, the valid signal indicating which bits are dummy bits.

13. The semiconductor device of one of the previous claims, wherein:
the morph-link circuit is configured to receive the streaming data in the first format at a variable data rate;
the first interface circuit is configured to cause transmitting the plurality of data bits in the second format at a second data rate; and
the morph-link circuit is configured to:
transmit a variable number of dummy bits to the first interface circuit, the variable number of dummy bits corresponding to a rate difference between the variable data rate and the second data rate; and
transmit a valid signal to the first interface circuit, the valid signal indicating which bits are dummy bits.

14. The semiconductor device of one of the previous claims, wherein the morph-link circuit comprises a buffer circuit configured to compensate for clock differences between a first clock signal for being utilized to provide the streaming data in the first format to the morph-link circuit and a second clock signal for being utilized by the first interface circuit for transmitting the plurality of data bits in the second format.

15. The semiconductor device of one of the previous claims,
wherein:
the morph-link circuit is configured to receive the streaming data in the first format at a first data rate, and
wherein the first interface circuit is configured to cause transmitting the plurality of data bits in the second format at the first data rate,
or wherein:
the morph-link circuit is configured to operate in accordance with a first clock signal,
the first interface circuit is configured to operate in accordance with a second clock signal, and
a rate of the first clock signal is less than a rate of the second clock signal,
or wherein:
the morph-link circuit configured to convert the streaming data to the second format is further configured to convert the streaming data in the first format comprising a plurality of parallel bit streams into the streaming data in the second format comprising one or more byte streams.
